# FASCICULE DE BREVET EUROPEEN

(11) **EP 3 931 855 B1**
(45) Date de publication et mention de la délivrance du brevet: **25.06.2025**
(21) Numéro de dépôt: 20704921.4
(22) Date de dépôt: 20.02.2020
(51) Int. Cl.: H01J 37/285, H01J 37/26

(54) **MICROSCOPE IONIQUE À EFFET DE CHAMP TOMOGRAPHIQUE AUTOMATISÉ**
AUTOMATISIERTES TOMOGRAPHIEFELDIONENMIKROSKOP
AUTOMATED TOMOGRAPHY FIELD ION MICROSCOPE

(30) Priorité: 01.03.2019 FR 1902139
(43) Date de publication de la demande: 05.01.2022
(73) Titulaire: Centre national de la recherche scientifique, 75016 Paris (FR); Institut National des Sciences Appliquees de Rouen (INSA), 76801 Saint Etienne du Rouvray (FR); Université de Rouen Normandie, 76821 Mont-Saint-Aignan (FR)
(72) Inventeur: VURPILLOT, François, 76120 LE GRAND QUEVILLY (FR); LARDE, Rodrigue, 76750 SAINTE CROIX SUR BUCHY (FR); KLAES, Benjamin, 76000 ROUEN (FR); DA COSTA, Gérald, 76120 LE GRAND QUEVILLY (FR)
(74) Mandataire: IPAZ
(86) Numéro de dépôt international: PCT/EP2020/054508
(87) Numéro de publication internationale: WO 2020/178038

(56) Documents cités:
- SHYAM KATNAGALLU ET AL: "Impact of local electrostatic field rearrangement on field ionization", JOURNAL OF PHYSICS D: APPLIED PHYSICS, INSTITUTE OF PHYSICS PUBLISHING LTD, GB, vol. 51, no. 10, 19 February 2018 (2018-02-19), pages 105601, XP020325141, ISSN: 0022-3727, [retrieved on 20180219], DOI: 10.1088/1361-6463/AAABA6
- FRANCOIS VURPILLOT ET AL: "True Atomic-Scale Imaging in Three Dimensions: A Review of the Rebirth of Field-Ion Microscopy", MICROSCOPY AND MICROANALYSIS, vol. 23, no. 2, 24 March 2017 (2017-03-24), pages 210 - 220, XP055649554, ISSN: 1431-9276, DOI: 10.1017/S1431927617000198
- HONO K ET AL: "A study of multi-layer G.P. zones in an A1-1.7 at. %Cu alloy by atom-probe fim", SCRIPTA METALLURGICA, ELSEVIER SCIENCE LTD., KIDLINGTON, GB, vol. 20, no. 4, 1 April 1986 (1986-04-01), pages 487 - 492, XP022810380, ISSN: 0036-9748, [retrieved on 19860401], DOI: 10.1016/0036-9748(86)90240-1
- JANG H ET AL: "Atomic scale observations of the chemical composition of a metal/ceramic interface", SCRIPTA METALLURGICA ET MATERIALIA, PERGAMON PRESS, GB, vol. 26, no. 9, 1 May 1992 (1992-05-01), pages 1493 - 1498, XP024181638, ISSN: 0956-716X, [retrieved on 19920501], DOI: 10.1016/0956-716X(92)90672-2
- HERSCHITZ R ET AL: "A quantitative atom-probe field-ion microscope study of the compositions of dilute Co(Nb) and Co(Fe) alloys", SURFACE SCIENCE, NORTH-HOLLAND, AMSTERDAM, NL, vol. 130, no. 1, 2 July 1983 (1983-07-02), pages 63 - 88, XP025757689, ISSN: 0039-6028, [retrieved on 19830702], DOI: 10.1016/0039-6028(83)90260-1

## Description

La présente invention concerne un procédé d'imagerie d'un matériau à l'échelle atomique et un microscope ionique à effet de champ.

Le microscope ionique à effet de champ est un instrument inventé dans les années 1950. Cet instrument présente de bonnes performances pour observer les défauts structuraux de matériaux, mais il reste peu utilisé. Son principal inconvénient est la difficulté de contrôler les paramètres optimaux d'imagerie durant l'acquisition de milliers d'images d'un matériau. Il est alors difficile de repérer efficacement les objets d'intérêt au cours de l'analyse. La variation de la qualité des images empêche notamment une extraction et une reconstruction correcte de l'information tridimensionnelle.

Traditionnellement, le matériau à analyser est préparé sous forme d'aiguille fine de faible rayon de courbure (inférieur à 200 nm) et placé dans une chambre à vide. Un gaz, dit gaz image, est introduit dans la chambre à vide et la pression ambiante de ce gaz, dans la chambre, est faible (inférieure à 0,1 Pa). Un potentiel continu intense (par exemple 20 kV) est appliqué à la pointe de l'aiguille, ce qui a pour effet de créer un champ électrique intense (supérieur à 20 V/nm) à la pointe de l'aiguille et d'ioniser le gaz image au-dessus des atomes de surface de la pointe. Les ions formés sont ensuite arrachés de la surface de la pointe par le champ électrique intense, et leur point d'impact, par exemple sur un écran, sont détectés. Comme la distribution du champ électrique est connue, on peut en déduire la trajectoire des ions arrachés et leur point de départ, ce qui permet de reconstruire la surface atomique de la pointe.

Afin d'obtenir une image résolue à une échelle sub-nanométrique et exploitable des atomes de surface imagés par le gaz, on peut faire varier la valeur du potentiel continu. Le potentiel permettant d'obtenir cette image optimale est appelé « potentiel de meilleure image ». Ce potentiel dépend à la fois de la nature du gaz image utilisé et du rayon de courbure de la pointe.

Il est également possible d'étudier la structure atomique interne du matériau constituant la pointe. Pour cela, on applique, en plus du potentiel continu, un potentiel impulsionnel à la pointe. Cela a pour effet d'éroder l'extrémité de la pointe, c'est-à-dire que des atomes de la surface de la pointe vont se détacher ou s'évaporer de la pointe. Le potentiel permettant cette évaporation est dit « potentiel d'évaporation ».

Le gaz image continue donc de s'ioniser sur la surface de la pointe érodée, ce qui permet de reconstruire la structure atomique interne du matériau constituant la pointe.

Néanmoins, l'érosion de la pointe a pour effet de modifier le rayon de courbure de la pointe. Donc la qualité des images des atomes de surface se dégrade au cours du temps. De plus, selon la valeur de potentiel impulsionnel appliquée, soit trop peu d'atomes s'évaporent, et dans ce cas, l'analyse de la structure interne du matériau risque d'être très coûteuse en temps ; soit un grand nombre d'atomes s'évaporent de la pointe, et dans ce cas, il est difficile de savoir si seulement un plan atomique s'est évaporé ou si plusieurs plans se sont évaporés. L'article de Vurpillot et al., intitulé « True atomic-scale imaging in three dimensions : a review of the rebirth of field-ion microscopy » et publié dans Microsc. Microanal. en 2017 propose d'appliquer un potentiel continu constant de 7 kV pour avoir un champ électrique continu d'évaporation à la surface de la pointe au début de l'analyse. L'érosion de la pointe est alors continue et s'effectue avec une vitesse de 0,5 nm/s. La reconstruction en trois dimensions de la structure du matériau se fait en traquant chaque atome sur toutes les images acquises de la pointe durant l'érosion. Cependant, les atomes ne sont pas tous visibles sur les images avec la même résolution, puisque le potentiel appliqué n'est pas toujours le potentiel de meilleure image, mais un potentiel de valeur non contrôlée, ce qui rend difficile la traque de certains atomes.

L'invention vise à remédier aux inconvénients précités de l'art antérieur, plus particulièrement elle vise à proposer un procédé d'imagerie d'un matériau à l'échelle atomique au moyen d'un microscope ionique à effet de champ permettant d'obtenir des images de même qualité pour chaque atome durant toute la durée de l'érosion de la pointe.

Un objet de l'invention est donc un procédé d'imagerie d'un matériau à l'échelle atomique au moyen d'un microscope ionique à effet de champ comprenant une chambre à vide configurée pour accueillir le matériau préparé sous forme de pointe et un gaz image, et un détecteur d'ions, caractérisé en ce qu'il comprend l'application d'un potentiel électrique continu et d'un potentiel électrique impulsionnel, dont la valeur maximale de l'impulsion est notée Vᵢₘₚ, de manière à ce que la pointe s'érode pour une valeur de potentiel égale à V_{DC}+Vᵢₘₚ ; l'acquisition, par le détecteur entre au moins deux impulsions du potentiel impulsionnel, de séries d'au moins deux images ioniques des impacts des ions détachés de la pointe sur le détecteur ; le calcul d'une grandeur caractéristique d'une évolution de l'érosion de la pointe à partir des séries d'images ioniques acquises et l'ajustement entre chaque série d'images des valeurs de V_{DC} et de Vᵢₘₚ de manière à ce que la grandeur caractéristique de l'évolution reste constante ou comprise dans un intervalle cible et le rapport V_{DC}/Vᵢₘₚ reste constant.

Selon des modes de réalisation de l'invention :
- le gaz image est un gaz ayant une pression inférieure à 0,1 Pa ;
- le gaz image est choisi parmi le néon, l'hélium, l'hydrogène, l'argon ou un mélange comprenant au moins un de ces gaz ; et
- la grandeur caractéristique de l'évolution de l'érosion est choisie parmi : une vitesse d'érosion de la pointe, un taux d'évaporation des atomes de la pointe ou un nombre d'atomes évaporés de la pointe.

Selon un mode de réalisation de l'invention, le procédé d'imagerie comprend les étapes suivantes :
a) Introduction d'un gaz image dans la chambre à vide ;
b) Application d'un potentiel électrique continu à la pointe de manière à créer une différence de potentiel électrique par rapport aux parois de la chambre à vide afin que le gaz image s'ionise sur une surface de la pointe et que des ions ainsi formés par le gaz image se détachent de la surface de la pointe et migrent vers le détecteur d'ions par effet de la différence de potentiel ;
c) Acquisition, par le détecteur, d'images ioniques des impacts des ions détachés de la pointe sur le détecteur pour différentes valeurs de potentiel électrique continu, calcul d'une première grandeur caractéristique d'une qualité des images ioniques pour chaque image acquise, sélection de l'image ionique ayant une qualité d'image souhaitée et définition d'une valeur de potentiel continu d'initialisation, noté V_{DC_init} et d'une valeur cible de cette première grandeur, notée Cᵢₙᵢₜ, V_{DC_init} et Cᵢₙᵢₜ étant le potentiel électrique continu et la première grandeur de l'image sélectionnée;
d) Application du potentiel électrique continu à la valeur V_{DC_init} et application d'un potentiel électrique impulsionnel, dont le maximum d'une impulsion est noté Vᵢₘₚ, à l'extrémité de la pointe de manière à provoquer une érosion de la pointe durant une impulsion ;
e) Acquisition entre au moins deux impulsions du potentiel impulsionnel, par le détecteur, d'images ioniques des impacts des ions détachés de la pointe érodée sur le détecteur pour différentes valeurs du maximum de l'impulsion Vᵢₘₚ, calcul d'une seconde grandeur caractéristique d'une évolution de l'érosion de la pointe pour des paires d'images acquises durant cette étape pour une même valeur de Vᵢₘₚ, sélection de la paire ayant l'évolution de l'érosion souhaitée, définition d'une valeur maximale cible de l'impulsion du potentiel électrique impulsionnel, dite impulsion d'initialisation et notée V_{imp_init}, correspondant à la valeur de l'impulsion maximale du potentiel électrique impulsionnel de la paire sélectionnée et définition d'un intervalle cible autour de la valeur de la seconde grandeur de la paire sélectionnée à l'étape e) ;
f) Acquisition, par le détecteur, par itérations et durant l'application du potentiel électrique continu et du potentiel électrique impulsionnel, de séries d'images ioniques des impacts des ions détachés de la pointe sur le détecteur entre au moins deux impulsions du potentiel impulsionnel, chaque série comprenant au moins deux images et à chaque itération, calcul de la seconde grandeur caractéristique de l'évolution de l'érosion de la pointe de la série acquise à cette itération, puis comparaison de cette seconde grandeur calculée avec des bornes de l'intervalle cible défini à l'étape e), et ajustement de la valeur de potentiel électrique continu appliqué et du maximum de l'impulsion du potentiel électrique impulsionnel (Vᵢₘₚ) appliqué de manière à ce que, pour l'itération suivante, les valeurs de la seconde grandeur caractéristique de l'évolution de l'érosion soient comprises dans l'intervalle cible et que le rapport V_{DC}/Vᵢₘₚ reste constant, pour la première itération, la valeur du potentiel continu est égale à V_{DC_init} et le maximum de l'impulsion du potentiel impulsionnel est égal à V_{imp_init}.
l'étape f) est réitérée jusqu'à ce qu'une condition d'arrêt soit satisfaite.

Selon d'autres modes de réalisation de l'invention :
- le procédé comprend une étape g) de reconstruction d'une image en trois dimensions à l'échelle atomique du matériau constituant la pointe à partir des séries d'images ioniques acquises à l'étape f) ;
- la première grandeur caractéristique de la qualité des images ioniques est choisie parmi : une résolution des images ioniques ou un contraste des images ioniques ;
- l'étape f) comprend, durant chaque itération, la réalisation d'une image différentielle obtenue par soustraction de deux images ioniques successives d'une même série ; et
- la condition d'arrêt est choisie parmi une atteinte d'un potentiel maximal, un arrêt manuel d'un utilisateur ou encore une rupture de la pointe.

Un autre objet de l'invention est un microscope ionique à effet de champ pour la mise en œuvre du procédé selon l'invention comprenant :
- une chambre à vide configurée pour recevoir un échantillon d'un matériau sous forme de pointe et pour recevoir un gaz ;
- un détecteur d'ions, configuré de manière à former des images ioniques d'impacts d'ions et à acquérir des images ioniques de ces impacts ;
- un générateur de potentiel continu configuré pour appliquer un potentiel électrique continu V_{DC} à la pointe ;
- un générateur de potentiel impulsionnel configuré pour appliquer un potentiel électrique impulsionnel dont la valeur maximale de l'impulsion est Vᵢₘₚ ;
- un système électronique configuré pour recevoir et traiter les images ioniques acquises par le détecteur, calculer une vitesse d'érosion de la pointe à partir des images ioniques acquises et à ajuster les valeurs de potentiel V_{DC} et de Vᵢₘₚ de manière à ce que une vitesse d'érosion de la pointe reste constante ou comprise dans un intervalle cible et à ce que le rapport V_{DC}/Vᵢₘₚ reste constant et à contrôler les générateurs de potentiel continu et de potentiel impulsionnel.

Selon un autre mode de réalisation, le détecteur comprend une caméra, des galettes de micro-canaux et un écran phosphorent, les galettes étant placées face à la pointe dans la chambre à vide, l'écran étant placé parallèlement derrière les galettes dans la chambre à vide et la caméra étant placée face à l'écran à l'extérieur de la chambre à vide.

D'autres caractéristiques, détails et avantages de l'invention ressortiront à la lecture de la description faite en référence aux figures annexées données à titre d'exemple et qui représentent, respectivement :
- [Fig.1], un schéma des étapes du procédé d'imagerie selon l'invention, et
- [Fig.2], un microscope ionique permettant de mettre en œuvre le procédé selon l'invention.

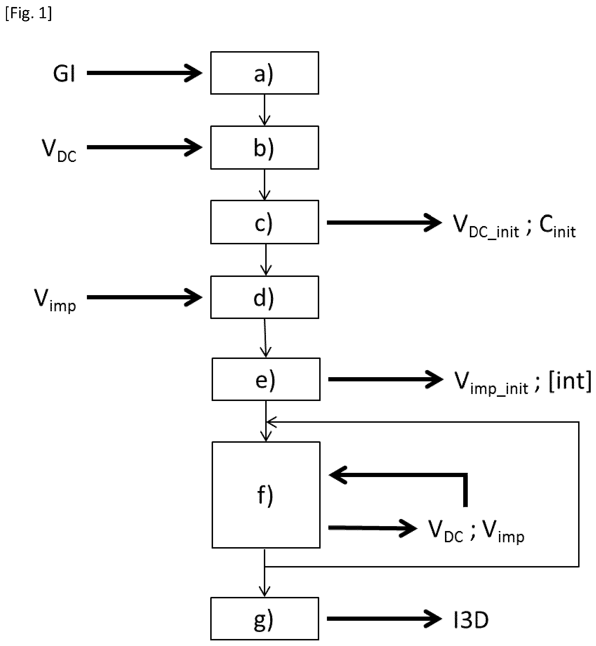

[Fig. 1] représente un schéma des étapes du procédé d'imagerie selon un mode de réalisation de l'invention. Le procédé permet d'analyser la structure cristalline interne d'un matériau. Ce matériau doit être préparé sous forme de pointe dont l'apex a un rayon de courbure inférieur à 200 nm. Cette pointe est placée dans la chambre à vide d'un microscope ionique à effet de champ comprenant également un détecteur d'ions.

La première étape du procédé (étape a)) consiste à introduire dans la chambre à vide du microscope un gaz image GI. Ce gaz image GI est à faible pression dans la chambre à vide et peut être choisi parmi du néon, de l'hélium, de l'hydrogène, de l'argon ou un autre gaz à une pression inférieure à 0,1 Pa (10⁻⁴ mbar).

Dans la seconde étape du procédé (étape b)), on applique un potentiel électrique continu V_{DC} à la pointe de manière à créer une différence de potentiel électrique par rapport aux parois de la chambre à vide. Cette différence de potentiel a pour effet de provoquer l'ionisation du gaz image GI au-dessus des atomes de la surface de la pointe. Toujours par effet de la différence de potentiel, les ions ainsi formés par le gaz image GI vont se détacher de la surface de la pointe et migrer vers le détecteur d'ions.

Dans l'étape c), on acquiert, grâce au détecteur d'ions, des images ioniques des impacts des ions, issus de l'ionisation du gaz image GI et détachés de la pointe sur le détecteur pour différentes valeurs de potentiel électrique continu V_{DC}. Chaque atome de la surface de la pointe est la source d'un faisceau d'ions. On calcule ensuite, dans cette étape, une première grandeur caractéristique de la qualité des images ioniques pour chaque image acquise. La grandeur calculée est, par exemple, la résolution de l'image ou le contraste de l'image.

Puis, on sélectionne l'image ionique présentant la qualité d'image souhaitée et on définit ainsi V_{DC_init} et Cᵢₙᵢₜ. V_{DC_init} est la valeur de potentiel électrique continu de l'image sélectionnée et Cᵢₙᵢₜ est la valeur de la première grandeur calculée de l'image sélectionnée. La valeur de potentiel V_{DC_init} est ainsi la valeur de potentiel de meilleure image qui permet d'obtenir une image nette des atomes en surface de la pointe durant l'ionisation du gaz image GI et tant que la pointe n'a pas commencé à s'éroder. En-dessous de cette valeur, certaines zones de la pointe sont peu visibles, car aucune ionisation du gaz ne se produit, tandis qu'au-dessus de cette valeur, l'ionisation du gaz GI n'a plus lieu à la surface de la pointe et l'image de la pointe devient alors floue.

Dans l'étape suivante (étape d)), on applique le potentiel électrique continu à la valeur V_{DC_init} et un potentiel électrique impulsionnel à l'extrémité de la pointe, dont la valeur maximale de l'impulsion est notée Vᵢₘₚ. La valeur maximale du potentiel impulsionnel (au moment de l'impulsion) vaut Vᵢₘₚ et sa valeur minimale vaut 0 V. Ces deux potentiels permettent de provoquer l'érosion de la pointe durant une impulsion. Les impulsions sont de très courte durée (de 0,1 ns à 100 ns) et sont reproduites à une cadence de quelques hertz à quelques centaines de kilohertz. L'érosion (ou l'évaporation des atomes) de la pointe se produit alors principalement sur le maximum de l'impulsion Vᵢₘₚ. Entre les impulsions, le taux d'évaporation est très faible, car bien inférieur à un atome par seconde. Dans la suite on considèrera qu'un taux d'évaporation exprime le nombre d'atomes qui s'évaporent par unité de temps, tandis qu'un taux d'érosion exprime la réduction d'une dimension caractéristique de la pointe par unité de temps.

Durant cette étape, on calcule également une seconde grandeur caractéristique de l'évolution de l'érosion de la pointe. On peut par exemple calculer le taux d'érosion de la pointe, ou la vitesse d'érosion de la pointe ou encore le nombre d'atomes évaporés. Cela peut se faire, par exemple :
- en mesurant localement la fréquence de variation d'intensité lumineuse, ce qui permet d'obtenir la vitesse d'évaporation de certains plans atomiques, ou
- plus directement en comptant le nombre d'atomes imagés sur chaque image, ou
- en calculant directement la différence du nombre d'atomes présents entre deux images d'une paire d'images acquises à la même valeur de V_{DC} + Vᵢₘₚ.

On sélectionne ensuite la paire d'images ioniques ayant une évolution de l'érosion souhaitée, c'est-à-dire ayant un taux d'érosion souhaité par l'utilisateur : par exemple, on sélectionne celle présentant un taux d'érosion de 100 atomes par seconde ou on sélectionne celle où 50 atomes se sont évaporés, etc ... Tout dépend de la précision souhaitée de l'analyse du matériau par l'utilisateur. S'il désire une analyse précise de la structure du matériau, l'utilisateur aura tendance à vouloir une évolution lente de l'érosion, donc une vitesse et un taux d'évaporation faibles alors que s'il souhaite une analyse rapide et non précise du matériau, il acceptera une vitesse d'érosion et un taux d'évaporation plus élevés.

A partir de la paire sélectionnée, on définit alors V_{imp_init} qui est la valeur maximale de l'impulsion du potentiel impulsionnel de l'image ou paire sélectionnée. A partir de cette valeur Vimp_init, on définit le facteur α = V_{imp_init} / V_{DC_init} qui sera constant en cours d'analyse. On définit également un intervalle cible [int] qui est un intervalle centré autour de la valeur de la seconde grandeur caractéristique de l'évolution de l'érosion de l'image ou paire sélectionnée. Par exemple, si la grandeur de l'image sélectionnée est un taux d'évaporation à 100 atomes par seconde, on peut définir l'intervalle cible [int] comme l'intervalle [50 atomes/s ; 150 atomes/s]. α définit la fraction de potentiel électrique impulsionnel pour l'intervalle cible choisi.

Les étapes b) à e) du procédé permettent d'initialiser le procédé.

L'étape suivante (étape f)) est une étape par itérations. A chaque itération, on applique un potentiel électrique continu et un potentiel électrique impulsionnel. Puis on acquiert, entre au moins deux impulsions du potentiel impulsionnel et à chaque itération, une série d'images ioniques des impacts des ions détachés de la pointe érodée sur le détecteur, on calcule ensuite la grandeur caractéristique de l'évolution de l'érosion et on la compare aux bornes de l'intervalle cible [int]. On ajuste alors la valeur du potentiel électrique continu et du maximum du potentiel électrique impulsionnel de manière à ce que les valeurs de la seconde grandeur caractéristique de l'évolution de l'érosion mesurées à la prochaine itération soient comprises dans l'intervalle cible [int] et à ce que le rapport V_{DC}/Vᵢₘₚ reste constant, c'est-à-dire que Vᵢₘₚ reste égal à V_{DC}/α à la prochaine itération avec une tolérance de quelques pourcents, par exemple 5% ou moins, de préférence 1% ou moins.

Par exemple, si la seconde grandeur est comprise dans l'intervalle avec une tolérance de quelques pourcents, par exemple de 5% ou moins, de préférence de 1% ou moins, on conserve les valeurs de Vᵢₘₚ et de V_{DC} de l'itération n pour l'itération suivante n+1, sinon elles sont modifiées pour l'itération n+1. En particulier, si la grandeur calculée est inférieure à la borne inférieure de l'intervalle cible [int], alors on augmente V_{DC} et Vᵢₘₚ, et si elle est supérieure à la borne supérieure de l'intervalle cible [int], alors on diminue V_{DC} et Vᵢₘₚ.

Pour la première itération, la valeur de V_{DC} appliquée est V_{DC_init} et la valeur de Vᵢₘₚ est V_{imp_init}.

L'étape g) est réitérée quand une condition d'arrêt est satisfaite. Cette condition d'arrêt peut être l'atteinte d'un potentiel maximal (par exemple quand V_{DC} atteint 15 kV), un arrêt manuel de l'utilisateur ou encore la rupture de l'échantillon analysé.

Ces ajustements des valeurs de V_{DC} et Vᵢₘₚ entre chaque itération sont nécessaires pour conserver une même qualité d'images entre chaque série d'images et une érosion constante. En effet, le rayon de courbure de la pointe augmente au fur et à mesure de l'érosion de la pointe, donc la valeur de potentiel de meilleure image varie, il faut donc modifier V_{DC} pour conserver des images de même qualité et surtout de bonne qualité. En modifiant V_{DC}, le potentiel total est modifié, ainsi que le champ électrique autour de la pointe, donc il faut également modifier Vᵢₘₚ pour conserver la même évolution de l'érosion de la pointe, c'est-à-dire la même vitesse d'érosion ou le même taux d'évaporation au fur et à mesure des itérations.

Puis l'étape suivante (étape h)) est la reconstruction d'une image en trois dimensions I3D de la structure atomique du matériau constituant la pointe à partir des séries d'images acquises à l'étape itérative g).

L'étape g) peut également comprendre, durant chaque itération, la réalisation d'une image différentielle obtenue par soustraction de deux images successives d'une même série. Cela permet notamment de calculer le nombre d'atomes évaporés entre deux images.

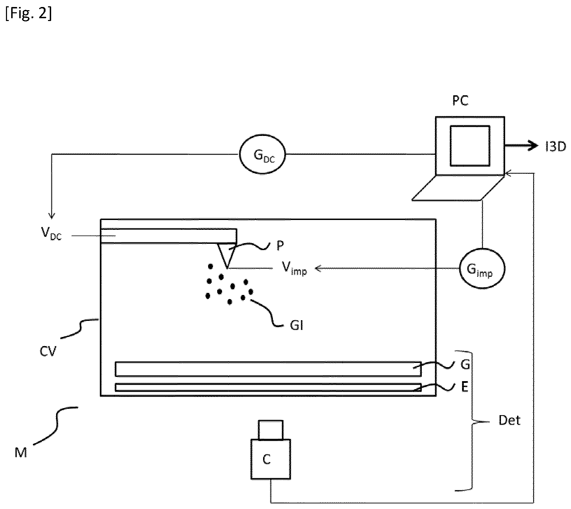

[Fig. 2] représente un microscope ionique selon l'invention permettant la mise en œuvre du procédé selon l'invention.

Ce microscope ionique M à effet de champ comprend une chambre à vide CV, un détecteur d'ions Det, un générateur de potentiel continu G_{DC} et un générateur de potentiel impulsionnel Gᵢₘₚ. La chambre à vide CV est configurée pour recevoir un échantillon d'un matériau préparé sous forme de pointe P et pour recevoir un gaz GI. Le microscope M comprend également un système informatique PC.

Le détecteur d'ions Det est configuré de manière à former des images à partir des impacts d'ions générés par la surface de la pointe et à acquérir des images ioniques de ces impacts. Le détecteur Det comprend des galettes de micro-canaux G permettant de transformer un impact d'ion en une gerbe d'électron et un écran phosphorent E qui transforme la gerbe d'électron en un spot lumineux. Le détecteur Det comprend également une caméra C qui acquiert des images des spots visibles sur l'écran E. La caméra C envoie ces images au système informatique PC qui va les traiter.

Les galettes de micro-canaux G sont placées face à la pointe P dans la chambre à vide CV et l'écran E est placé parallèlement derrière les galettes G dans la chambre à vide CV. La caméra C est placée face à l'écran E à l'extérieur de la chambre à vide CV.

Si l'on ne souhaite pas placer la caméra C en face de l'écran E, pour des raisons d'encombrement par exemple, il est possible de la décaler par rapport à l'écran et d'utiliser un miroir entre les deux.

Le générateur de potentiel continu G_{DC} est configuré de manière à appliquer un potentiel électrique continu V_{DC} à la pointe P. Ce générateur G_{DC} est contrôlé par le système informatique PC.

Le générateur de potentiel impulsionnel Gᵢₘₚ est configuré de manière à appliquer un potentiel électrique impulsionnel Vᵢₘₚ à l'extrémité de la pointe P.

Les générateurs Gᵢₘₚ et G_{DC} peuvent être deux générateurs distincts, comme représentés sur la figure. Il est également possible d'avoir un seul générateur capable de délivrer un potentiel électrique impulsionnel dont la valeur maximale (au moment de l'impulsion) vaut V_{DC}+Vᵢᵣₙₚ et dont la valeur minimale vaut V_{DC}.

Le système informatique PC est configuré pour recevoir et traiter les images ioniques acquises par le détecteur Det, en particulier par la caméra C. Il est également configuré pour calculer une grandeur caractéristique de la qualité des images ioniques acquises, comme par exemple la résolution ou le contraste de l'image. Il est configuré pour calculer une grandeur caractéristique de l'évolution de l'érosion, il peut ainsi calculer la vitesse d'érosion de la pointe et/ou le taux d'évaporation de la pointe et/ou le nombre d'atomes évaporés. Il est également configuré pour calculer l'ajustement des valeurs de potentiel continu (V_{DC}) et de maximum de l'impulsion du potentiel impulsionnel (Vᵢₘₚ) et pour contrôler les générateurs de potentiel continu (G_{DC}) et de potentiel impulsionnel (Gᵢₘₚ).

Selon un autre mode de réalisation de l'invention, le système informatique PC est également configuré pour reconstruire une image en trois dimensions I3D de la structure du matériau constituant la pointe à partir des différentes images ioniques acquises par le détecteur Det.

Selon un autre mode de réalisation de l'invention, le système informatique PC est configuré pour réaliser une image différentielle issue de la soustraction de deux images ioniques.

Selon un autre mode de réalisation de l'invention, le système informatique PC est configuré pour appliquer un algorithme de détection de spots lumineux sur les images ioniques et/ou sur une image différentielle.

Selon un autre mode de réalisation, le détecteur d'ions D comprend des galettes de micro-canaux et un système de localisation spatial de la gerbe d'électron de type anode résistive ou ligne à retard.

Selon un autre mode de réalisation, le détecteur d'ions Det comprend un capteur à transfert de charges (CCD) ou un capteur à « semi-conducteur à oxyde de métal complémentaire » (CMOS) placé directement en face de la pointe. Dans ce cas, le détecteur peut également comprendre un amplificateur.

## Revendications

1. Procédé d'imagerie d'un matériau à l'échelle atomique au moyen d'un microscope ionique (M) à effet de champ comprenant une chambre à vide (CV) configurée pour accueillir le matériau préparé sous forme de pointe (P) et un gaz image (GI), et un détecteur d'ions (Det), **caractérisé en ce qu'**il comprend l'application d'un potentiel électrique continu (V_{DC}) et d'un potentiel électrique impulsionnel, dont la valeur maximale de l'impulsion est notée Vᵢₘₚ, de manière à ce que la pointe s'érode pour une valeur de potentiel égale à V_{DC}+Vᵢₘₚ ; l'acquisition, par le détecteur entre au moins deux impulsions du potentiel impulsionnel, de séries d'au moins deux images ioniques des impacts des ions détachés de la pointe sur le détecteur ; le calcul d'une grandeur caractéristique d'une évolution de l'érosion de la pointe à partir des séries d'images ioniques acquises et l'ajustement entre chaque série d'images des valeurs de V_{DC} et de Vᵢₘₚ de manière à ce que la grandeur caractéristique de l'évolution reste constante ou comprise dans un intervalle cible et le rapport V_{DC}/Vᵢₘₚ reste constant.

2. Procédé d'imagerie selon la revendication 1 dans lequel le gaz image est un gaz ayant une pression inférieure à 0,1 Pa.

3. Procédé d'imagerie selon l'une des revendications 1 à 2 dans lequel le gaz image est choisi parmi le néon, l'hélium, l'hydrogène, l'argon ou un mélange comprenant au moins un de ces gaz.

4. Procédé d'imagerie selon l'une des revendications 1 à 3 dans lequel la grandeur caractéristique de l'évolution de l'érosion est choisie parmi : une vitesse d'érosion de la pointe, un taux d'évaporation des atomes de la pointe ou un nombre d'atomes évaporés de la pointe.

5. Procédé d'imagerie selon l'une des revendications 1 à 4 comprenant les étapes suivantes :
a) Introduction d'un gaz image (GI) dans la chambre à vide ;
b) Application d'un potentiel électrique continu (V_{DC}) à la pointe de manière à créer une différence de potentiel électrique par rapport aux parois de la chambre à vide afin que le gaz image s'ionise sur une surface de la pointe et que des ions ainsi formés par le gaz image se détachent de la surface de la pointe et migrent vers le détecteur d'ions par effet de la différence de potentiel ;
c) Acquisition, par le détecteur, d'images ioniques des impacts des ions détachés de la pointe sur le détecteur pour différentes valeurs de potentiel électrique continu (V_{DC}), calcul d'une première grandeur caractéristique d'une qualité des images ioniques pour chaque image acquise, sélection de l'image ionique ayant une qualité d'image souhaitée et définition d'une valeur de potentiel continu d'initialisation, noté V_{DC_init} et d'une valeur cible de cette première grandeur, notée Cᵢₙᵢₜ, V_{DC_init} et Cᵢₙᵢₜ étant le potentiel électrique continu et la première grandeur de l'image sélectionnée;
d) Application du potentiel électrique continu à la valeur V_{DC_init} et application d'un potentiel électrique impulsionnel, dont le maximum d'une impulsion est noté Vᵢₘₚ, à l'extrémité de la pointe de manière à provoquer une érosion de la pointe durant une impulsion ;
e) Acquisition entre au moins deux impulsions du potentiel impulsionnel, par le détecteur, d'images ioniques des impacts des ions détachés de la pointe érodée sur le détecteur pour différentes valeurs du maximum de l'impulsion Vᵢₘₚ, calcul d'une seconde grandeur caractéristique d'une évolution de l'érosion de la pointe pour des paires d'images acquises durant cette étape pour une même valeur de Vᵢₘₚ, sélection de la paire ayant l'évolution de l'érosion souhaitée, définition d'une valeur maximale cible de l'impulsion du potentiel électrique impulsionnel, dite impulsion d'initialisation et notée V_{imp_init}, correspondant à la valeur de l'impulsion maximale du potentiel électrique impulsionnel de la paire sélectionnée et définition dudit intervalle cible ([int]) autour de la valeur de la seconde grandeur de la paire sélectionnée à l'étape e) ;
f) Acquisition, par le détecteur, par itérations et durant l'application du potentiel électrique continu et du potentiel électrique impulsionnel, de séries d'images ioniques des impacts des ions détachés de la pointe sur le détecteur entre au moins deux impulsions du potentiel impulsionnel, chaque série comprenant au moins deux images et à chaque itération, calcul de la seconde grandeur caractéristique de l'évolution de l'érosion de la pointe de la série acquise à cette itération, puis comparaison de cette seconde grandeur calculée avec des bornes de l'intervalle cible ([int]) défini à l'étape e), et ajustement de la valeur de potentiel électrique continu (V_{DC}) appliqué et du maximum de l'impulsion du potentiel électrique impulsionnel (Vᵢₘₚ) appliqué de manière à ce que, pour l'itération suivante, les valeurs de la seconde grandeur caractéristique de l'évolution de l'érosion soient comprises dans l'intervalle cible et que le rapport V_{DC}/Vᵢₘₚ reste constant, pour la première itération, la valeur du potentiel continu est égale à V_{DC_init} et le maximum de l'impulsion du potentiel impulsionnel est égal à V_{imp_init}.
l'étape f) est réitérée jusqu'à ce qu'une condition d'arrêt soit satisfaite.

6. Procédé d'imagerie selon la revendication 5 comprenant une étape g) de reconstruction d'une image en trois dimensions (I3D) à l'échelle atomique du matériau constituant la pointe à partir des séries d'images ioniques acquises à l'étape f).

7. Procédé d'imagerie selon l'une des revendications 5 à 6 dans lequel la première grandeur caractéristique de la qualité des images ioniques est choisie parmi : une résolution des images ioniques ou un contraste des images ioniques.

8. Procédé d'imagerie selon l'une des revendications 5 à 7 dans lequel l'étape f) comprend, durant chaque itération, la réalisation d'une image différentielle obtenue par soustraction de deux images ioniques successives d'une même série.

9. Procédé d'imagerie selon l'une des revendications 5 à 8 dans lequel la condition d'arrêt est choisie parmi une atteinte d'un potentiel maximal, un arrêt manuel d'un utilisateur ou encore une rupture de la pointe.

10. Microscope ionique à effet de champ pour la mise en œuvre du procédé selon l'une des revendications précédentes comprenant :
- une chambre à vide (CV) configurée pour recevoir un échantillon d'un matériau sous forme de pointe (P) et pour recevoir un gaz (GI) ;
- un détecteur d'ions (Det), configuré de manière à former des images ioniques d'impacts d'ions et à acquérir des images ioniques de ces impacts ;
- un générateur de potentiel continu (G_{DC}) configuré pour appliquer un potentiel électrique continu V_{DC} à la pointe ;
- un générateur de potentiel impulsionnel (Gᵢₘₚ) configuré pour appliquer un potentiel électrique impulsionnel dont la valeur maximale de l'impulsion est Vᵢₘₚ ;
- un système électronique (PC) configuré pour recevoir et traiter les images ioniques acquises par le détecteur, calculer une vitesse d'érosion de la pointe à partir des images ioniques acquises et à ajuster les valeurs de potentiel V_{DC} et de Vᵢₘₚ de manière à ce que une vitesse d'érosion de la pointe reste constante ou comprise dans un intervalle cible et à ce que le rapport V_{DC}/Vᵢₘₚ reste constant et à contrôler les générateurs de potentiel continu et de potentiel impulsionnel.

11. Microscope selon la revendication 10 dans lequel le détecteur comprend une caméra (C), des galettes de micro-canaux (G) et un écran phosphorent (E), les galettes étant placées face à la pointe dans la chambre à vide, l'écran étant placé parallèlement derrière les galettes dans la chambre à vide et la caméra étant placée face à l'écran à l'extérieur de la chambre à vide.

## Patentansprüche

1. Verfahren zur Bildgebung eines Materials auf atomarer Ebene unter Verwendung eines Feldeffekt-Ionenmikroskops (M), umfassend eine Vakuumkammer (CV), die konfiguriert ist, um das in Spitzenform (P) vorbereitete Material und ein Bildgas (GI) aufzunehmen, und einen Ionendetektor (Det), **dadurch gekennzeichnet, dass** es das Anlegen eines elektrischen Dauerpotentials (V_{DC}) und eines elektrischen Impulspotentials, dessen maximaler Impulswert mit Vᵢₘₚ bezeichnet wird, so dass die Spitze bei einem Potentialwert gleich V_{DC}+Vᵢₘₚ erodiert; das Erfassen, durch den Detektor zwischen mindestens zwei Impulsen des Impulspotentials von Serien von mindestens zwei Ionenbildern der Einschläge der von der Spitze abgelösten Ionen auf dem Detektor; das Berechnen einer charakteristischen Größe einer Entwicklung der Erosion der Spitze aus den Serien der erfassten Ionenbilder, und das Anpassen zwischen jeder Bildserie der Werte von V_{DC} und Vᵢₘₚ umfasst, so dass die charakteristische Größe der Entwicklung konstant bleibt oder in einem Zielintervall enthalten ist und das Verhältnis V_{DC}/Vᵢₘₚ konstant bleibt.

2. Bildgebungsverfahren nach Anspruch 1, wobei das Bildgas ein Gas mit einem Druck von weniger als 0,1 Pa ist.

3. Bildgebungsverfahren nach einem der Ansprüche 1 bis 2, wobei das Bildgas ausgewählt wird aus Neon, Helium, Wasserstoff, Argon oder einer Mischung, die mindestens eines dieser Gase umfasst.

4. Bildgebungsverfahren nach einem der Ansprüche 1 bis 3, wobei die charakteristische Größe der Erosionsentwicklung ausgewählt wird aus: einer Erosionsgeschwindigkeit der Spitze, einer Verdampfungsrate der Atome der Spitze oder einer Anzahl von Atomen, die von der Spitze verdampft werden.

5. Bildgebungsverfahren nach einem der Ansprüche 1 bis 4, umfassend die folgenden Schritte:
a) Einleiten eines Bildgases (IG) in die Vakuumkammer;
b) Anlegen eines elektrischen Dauerpotentials (V_{DC}) an der Spitze, um eine Differenz des elektrischen Potentials relativ zu den Wänden der Vakuumkammer zu erzeugen, so dass das Bildgas auf einer Oberfläche der Spitze ionisiert und sich die so durch das Bildgas gebildeten Ionen von der Oberfläche der Spitze lösen und durch die Wirkung der Potentialdifferenz in Richtung des Ionendetektors wandern;
c) Erfassen, durch den Detektor, von Ionenbildern der Einschläge der von der Spitze abgelösten Ionen auf dem Detektor bei unterschiedlichen Werten des elektrischen Dauerpotentials (V_{DC}), Berechnen einer ersten charakteristischen Größe einer Qualität der Ionenbilder für jedes erfasste Bild, Auswählen des Ionenbildes mit einer gewünschten Bildqualität, und Definieren eines Initialisierungsdauerpotentialwertes, bezeichnet mit V_{DV_init}, und eines Zielwerts dieser ersten Größe, bezeichnet mit Cᵢₙᵢₜ, V_{DV_init} und Cᵢₙᵢₜ, der das elektrische Dauerpotential und die erste Größe des ausgewählten Bildes ist;
d) Anlegen des elektrischen Dauerpotentials auf den Wert V_{DC_init}, und Anlegen eines elektrischen Impulspotentials, dessen Maximum eines Impulses als Vᵢₘₚ bezeichnet wird, am Spitzenende, so dass während eines Impulses eine Erosion der Spitze provoziert wird;
e) Erfassen von Ionenbildern der Einschläge der von der erodierten Spitze abgelösten Ionen auf dem Detektor zwischen mindestens zwei Impulsen des Impulspotentials, durch den Detektor, für unterschiedliche Werte des Maximums des Impulses Vᵢₘₚ, Berechnen einer zweiten charakteristischen Größe einer Entwicklung der Erosion der Spitze für Bilderpaare, die während dieses Schritts für den gleichen Wert von Vᵢₘₚ erfasst wurden, Auswählen des Paares mit der gewünschten Erosionsentwicklung, Definieren eines maximalen Zielwertes des Impulses des elektrischen Impulspotentials, genannt Initialisierungsimpuls und bezeichnet mit V_{imp_init}, der dem Wert des maximalen Impulses des elektrischen Impulspotentials des ausgewählten Paares entspricht, und Definieren des Zielintervalls ([int]) um den Wert der zweiten Größe des in Schritt e) ausgewählten Paares;
f) Erfassen, durch den Detektor, durch Iterationen und während des Anlegens des elektrischen Dauerpotentials und des elektrischen Impulspotentials, zwischen mindestens zwei Impulsen des Impulspotentials von Serien von Ionenbildern der Einschläge der von der Spitze abgelösten Ionen auf dem Detektor, wobei jede Serie mindestens zwei Bilder umfasst, und bei jeder Iteration Berechnen der zweiten Größe, die für die Entwicklung der Erosion der Spitze der bei dieser Iteration erfassten Serie charakteristisch ist, anschließend Vergleichen dieser berechneten zweiten Größe mit den Grenzen des Zielintervalls ([int]), das in Schritt e) definiert wurde, und Anpassen des Wertes des angelegten elektrischen Dauerpotentials (V_{DC}) und des angelegten Maximums des Impulses des elektrischen Impulspotentials (Vᵢₘₚ), so dass für die folgende Iteration die Werte der zweiten charakteristischen Größe der Erosionsentwicklung im Zielintervall enthalten sind und das Verhältnis V_{DC}/Vᵢₘₚ konstant bleibt, für die erste Iteration ist der Wert des Dauerpotentials gleich V_{DC_init} und das Maximum des Impulses des Impulspotentials ist gleich V_{imp_init}.
Schritt f) wird wiederholt, bis eine Abbruchbedingung erfüllt ist.

6. Bildgebungsverfahren nach Anspruch 5, umfassend einen Schritt g) zum Rekonstruieren eines dreidimensionalen Bildes (I3D) im atomaren Maßstab des Materials, aus dem die Spitze besteht, aus den Serien der in Schritt f) erfassten Ionenbilder.

7. Bildgebungsverfahren nach einem der Ansprüche 5 bis 6, wobei die erste für die Qualität der Ionenbilder charakteristische Größe ausgewählt wird aus: einer Auflösung der Ionenbilder oder einem Kontrast der Ionenbilder.

8. Bildgebungsverfahren nach einem der Ansprüche 5 bis 7, wobei Schritt f) während jeder Iteration die Erzeugung eines Differenzbildes umfasst, das durch Subtraktion zweier aufeinanderfolgender Ionenbilder aus derselben Serie erhalten wird.

9. Bildgebungsverfahren nach einem der Ansprüche 5 bis 8, wobei die Abbruchbedingung ausgewählt wird aus dem Erreichen eines Maximalpotentials, einem manueller Abbruch durch einen Benutzer oder auch einem Bruch der Spitze.

10. Feldeffekt-Ionenmikroskop zur Durchführung des Verfahrens nach einem der vorstehenden Ansprüche, umfassend:
- eine Vakuumkammer (CV), die konfiguriert ist, um eine Materialprobe in Form einer Spitze (P) aufzunehmen und um ein Gas (GI) aufzunehmen;
- einen Ionendetektor (Det), der konfiguriert ist, um Ionenbilder von Ioneneinschlägen zu erzeugen und Ionenbilder dieser Einschläge zu erfassen;
- einen Dauerpotentialgenerator (G_{DC}), der konfiguriert ist, um ein elektrisches Dauerpotential V_{DC} an der Spitze anzulegen;
- einen Impulspotentialgenerator (Gᵢₘₚ), der konfiguriert ist, um ein elektrisches Impulspotential anzulegen, deren maximaler Impulswert Vᵢₘₚ beträgt;
- ein elektronisches System (PC), das konfiguriert ist, um die durch den Detektor erfassten Ionenbilder zu empfangen und zu verarbeiten, aus den erfassten Ionenbildern eine Spitzenerosionsgeschwindigkeit zu berechnen und die Potentialwerte V_{DC} und Vᵢₘₚ so anzupassen, dass die Spitzenerosionsgeschwindigkeit konstant bleibt oder innerhalb eines Zielbereichs liegt, und dass das Verhältnis V_{DC}/Vᵢₘₚ konstant bleibt, und um die Generatoren für Dauerpotential und Impulspotential zu steuern.

11. Mikroskop nach Anspruch 10, wobei der Detektor eine Kamera (C), Mikrokanal-Wafer (G) und einen Leuchtschirm (E) umfasst, wobei die Wafer mit Blick auf die Spitze in der Vakuumkammer platziert sind, wobei der Schirm parallel hinter den Wafern in der Vakuumkammer platziert ist, und wobei die Kamera mit Blick auf den Schirm außerhalb der Vakuumkammer platziert ist.

## Claims

1. A method for imaging an atomic-scale material by means of a field ion microscope (M) comprising a vacuum chamber (CV) configured to accommodate the prepared material in the form of a tip (P) and an image gas (GI), and an ion detector (Det), **characterized in that** it comprises the application of a direct-current electrical potential (V_{DC}) and of a pulsed electrical potential, the maximum value of the pulse of which is denoted Vᵢₘₚ, so that the tip erodes for a potential value equal to V_{DC}+Vᵢₘₚ; acquisition by the detector, between at least two pulses of the pulsed potential, of series of at least two ion images of the impacts of ions detached from the tip on the detector; calculation of a quantity characteristic of an evolution of the erosion of the tip from the series of ion images acquired and adjustment between each series of images of the values of V_{DC} and Vᵢₘₚ so that the quantity characteristic of the trend remains constant or within a target range and the ratio V_{DC}/Vᵢₘₚ remains constant.

2. The imaging method according to claim 1, wherein the image gas is a gas having a pressure of less than 0.1 Pa.

3. The imaging method according to one of claims 1 to 2, wherein the image gas is chosen from neon, helium, hydrogen, argon or a mixture comprising at least one of these gases.

4. The imaging method according to one of claims 1 to 3, wherein the quantity characteristic of the erosion trend is selected from: a tip erosion rate, a tip atom evaporation rate, or a number of evaporated tip atoms.

5. The imaging method according to one of claims 1 to 4 comprising the following steps:
a) Introduction of an image gas (GI) into the vacuum chamber;
b) Application of a direct electrical potential (V_{DC}) to the tip so as to create an electrical potential difference with respect to the walls of the vacuum chamber, so that the image gas ionizes on a surface of the tip and ions thus formed by the image gas detach from the surface of the tip and migrate to the ion detector as a result of the potential difference;
c) Acquisition, by the detector, of ion images of the impacts of ions detached from the tip on the detector for different values of direct-current electrical potential (V_{DC}), calculation of a first quantity characteristic of a quality of the ion images for each image acquired, selecting the ion image with the desired image quality and defining an initialization DC potential value, denoted V_{DV_init}, and a target value for this first quantity, denoted Cᵢₙᵢₜ, where V_{DV_init} et Cᵢₙᵢₜ are the direct-current electrical potential and the first quantity of the selected image;
d) Application of the direct-current electrical potential at the value V_{DC_init} and application of a pulsed electrical potential, the maximum of a pulse of which is denoted Vᵢₘₚ, to the end of the tip so as to cause erosion of the tip during a pulse;
e) Acquisition by the detector, between at least two pulses of the pulsed potential, of ion images of the impacts of ions detached from the eroded tip on the detector for different values of the maximum of the pulse Vᵢₘₚ, calculation of a second quantity characteristic of an erosion trend of the tip for pairs of images acquired during this step for the same value of Vᵢₘₚ, selection of the pair having the desired erosion trend, definition of a target maximum value of the pulse electric potential, called initialization pulse and denoted V_{imp_init}, corresponding to the value of the maximum pulsed electric potential of the selected pair and definition of said target interval ([int]) around the value of the second quantity of the pair selected in step e);
f) Acquisition, by the detector, in iterations and during the application of the direct-current electric potential and of the pulsed electric potential, of series of ion images of the impacts of the ions detached from the tip on the detector between at least two pulses of the pulsed potential, each series comprising at least two images and at each iteration, calculation of the second quantity characteristic of the erosion trend of the tip of the series acquired at this iteration, then comparison of this calculated second quantity with bounds of the target interval ([int]) defined in step e), and adjusting the value of the direct-current electrical potential (V_{DC}) applied and the maximum of the pulse of the pulsed electrical potential (Viₘₚ) applied in such a way that, for the next iteration, the values of the second quantity characteristic of the erosion trend lie within the target interval and the ratio V_{DC}/Vᵢₘₚ remains constant, for the first iteration, the value of the direct-current potential is equal to V_{DC_init} and the maximum of the pulse of the pulsed potential is equal to V_{imp_init}.
step f) is repeated until a stop condition is satisfied.

6. The imaging method according to claim 5 comprising a step g) of reconstructing an atomic-scale three-dimensional image (13D) of the tip material from the series of ion images acquired in step f).

7. The imaging method according to one of claims 5 to 6, wherein the first quantity characteristic of the quality of the ion images is chosen from: a resolution of the ion images or a contrast of the ion images.

8. The imaging method according to one of claims 5 to 7, wherein step f) comprises, during each iteration, the production of a differential image obtained by subtracting two successive ion images from the same series.

9. The imaging method according to one of claims 5 to 8 wherein the stop condition is selected from a maximum potential being reached, a manual stop by a user, or the tip breaking.

10. A field ion microscope for carrying out the method according to one of the preceding claims, comprising:
- a vacuum chamber (CV) configured to receive a sample of a material in the form of a tip (P) and to receive a gas (GI);
- an ion detector (Det), configured to form ion images of ion impacts and to acquire ion images of these impacts;
- a direct-current potential generator (G_{DC}) configured to apply a direct-current electrical potential V_{DC} to the tip;
- a pulsed potential generator (Gᵢₘₚ) configured to apply a pulsed electrical potential whose maximum pulse value is Vᵢₘₚ;
- an electronic system (PC) configured to receive and process ion images acquired by the detector, to calculate a tip erosion rate from the acquired ion images, and to adjust the V_{DC} and Vᵢₘₚ potential values so that a tip erosion rate remains constant or within a target range and the V_{DC}/Vᵢₘₚ ratio remains constant, and to control the direct-current and pulsed potential generators.

11. The microscope according to claim 10, wherein the detector comprises a camera (C), microchannel plates (G) and a phosphor screen (E), the plates being positioned facing the tip in the vacuum chamber, the screen being positioned parallel behind the plates in the vacuum chamber and the camera being positioned facing the screen outside the vacuum chamber.
